# EUROPEAN PATENT SPECIFICATION

(11) **EP 2 903 019 B1**
(45) Date of publication and mention of the grant of the patent: **06.11.2019**
(21) Application number: 13842461.9
(22) Date of filing: 25.09.2013
(51) Int. Cl.: H01L 21/3065, H05H 1/46, H01J 37/32

(54) **PLASMA ETCHING DEVICE**
PLASMAÄTZVORRICHTUNG
DISPOSITIF DE GRAVURE PAR PLASMA

(30) Priority: 27.09.2012 JP 2012214039
(43) Date of publication of application: 05.08.2015
(73) Proprietor: SPP Technologies Co., Ltd., Tokyo 100-0004 (JP)
(72) Inventor: YAMAMOTO, Takashi, Amagasaki-shi Hyogo 660-0891 (JP); OTA, Kazuya, Amagasaki-shi Hyogo 660-0891 (JP); SASAKURA, Masahiro, Amagasaki-shi Hyogo 660-0891 (JP); HAYASHI, Yasuyuki, Amagasaki-shi Hyogo 660-0891 (JP)
(74) Representative: Isarpatent
(86) International application number: PCT/JP2013/075933
(87) International publication number: WO 2014/050903

(56) References cited:
- WO-A2-2005/034163
- JP-A- H09 162 178
- JP-A- 2004 079 465
- JP-A- 2004 079 465
- JP-A- 2010 238 847
- US-A1- 2003 111 963
- US-A1- 2012 006 490

## Description

### Technical Field

0001 The present invention relates to a plasma etching device that generates plasma from an etching gas to etch a substrate surface, and particularly relates to a plasma etching device that uniformizes in-plane density of generated plasma to enable uniform etching of an entire substrate surface.

### Background Art

0002 A plasma etching device performing inductively coupled reactive ion etching, which is a type of the above-mentioned plasma etching device, generally incudes a cylindrical chamber having a plasma generation space set therein, a coil disposed outside the chamber corresponding to the plasma generation space, a mechanism for supplying RF power to the coil, a mechanism for supplying an etching gas into the plasma generation space, a mechanism for exhausting gas inside the chamber, etc. This plasma etching device generates an inductive electric field by applying RF power to the coil, and then supplies an etching gas into the plasma generation space and generates plasma from the etching gas by the inductive electric field, and etches a substrate surface by the generated plasma.

0003 Incidentally, in recent years, the size of a target substrate to be processed has been increased, and in the case where such a large-size substrate is to be processed using the above-mentioned conventional plasma etching device, the plasma generation space has to be enlarged by enlarging the chamber in accordance with the size of the substrate.

0004 By the way, in the plasma generation space, the inductive electric field easily functions at a portion close to the coil and plasma is easily generated there, while the inductive electric field hardly functions at a portion away from the coil (a central portion) and plasma is hardly generated there. Therefore, by enlarging the plasma generation space, in-plane density of the generated plasma is caused to have a concave density distribution where the density is high at the portion close to the coil and low at the portion away from the coil.

0005 If in-plane density of the plasma has a concave density distribution as described above, when the plasma functions on a substrate as it is, an outer peripheral portion of the substrate is etched more than an inner portion thereof, which results in the problem that the substrate surface is not uniformly etched and the problem that a tilt occurs where an etching shape is tilted from a direction perpendicular to the substrate surface.

0006 Accordingly, as a plasma etching device for solving the above-described problems, the applicant of the present application has already suggested the plasma etching device described in Japanese Unexamined Patent Application Publication No. 2010-238847 (referred to as "the conventional device" below).

0007 This conventional device includes a cylindrical chamber having a plasma generation space set in an upper portion thereof and a processing space set in a lower portion thereof, a coil disposed outside a portion of the chamber where the plasma generation space is set, a platen disposed in the processing space, a mechanism for supplying an etching gas into the plasma generation space, a mechanism for exhausting gas inside the chamber, a mechanism for applying RF power to the coil and to the platen, a plasma density adjusting member made of a cylindrical member having an opening at an upper portion and at a lower portion and having the upper portion fixed on an inner wall of the chamber between the plasma generation space and the platen, etc. The plasma density adjusting member is formed in a funnel shape whose lower end portion has an inner diameter smaller than the inner diameter of its upper end portion and the inner diameter of the chamber forming the plasma generation space. Further, a cylindrical core member is arranged at a central portion of a top plate closing the upper portion of the chamber so that it hangs downward therefrom; the plasm generation space is formed in a doughnut shape by the core member.

0008 According to this conventional device, first, an inductive electric field is generated in the plasma generation space by applying RF power to the coil. Subsequently, in this state, an etching gas is supplied into the plasma generation space and plasma is generated from the supplied etching gas by the inductive electric field. The thus generated plasma flows downward and flows through the funnel-shaped plasma density adjusting member, and thereby the plasma generated at a portion close to the coil is led to a central portion of the chamber and an extremely concave in-plane density of the plasma is leveled. Thereafter, the plasma reaches a substrate placed on the platen.

0009 Thus, in the conventional device, it is possible to cause plasma having a uniform in-plane density to function on a substrate; therefore, it is possible to uniformly etch an entire substrate surface.

0010 US 2012/0006490 A1 discloses a plasma etching apparatus with a chamber having a plasma generating space and a processing space, a coil disposed on the outside of a portion corresponding to the plasma generating space, a platen which is provided in the processing space and on which a substrate is to be placed, a processing gas supply mechanism for supplying a processing gas into the plasma generating space, an RF power supply mechanism for supplying RF power to the coil, and a power supply mechanism for platen for supplying RF power to the platen. A cylindrical plasma density adjusting member which is made of a conductive material grounded is fixedly provided on an inner wall on the chamber between the plasma generating space and the platen.

0011 Further examples of such a plasma etching apparatus are described in JP 2004 079465 A, US 2003/111963 A1 and WO 2005/034163 A2.

### Summary of Invention

### Technical Problem

0012 Incidentally, although some effects are obtained from the above-described conventional device in view of the fact that the in-plane density of the plasma is uniformized by allowing the plasma to flow through the plasma density adjusting member, in recent years, partially because there has been a desire to etch an entire substrate surface with higher uniformity, improvement for increasing uniformity of the in-plane density of plasma has been desired so as to respond to the desire.

0013 That is, in the above-described conventional device, although the in-plane density of the plasma can be almost leveled by allowing the plasma to flow through the plasma density adjusting member, there is the case where just allowing the plasma to flow through the plasma density adjusting member is not sufficient to allow a sufficient amount of plasma to be led to the central portion of the chamber, and the in-plane density of the plasma tends to have a slightly center-recessed, M-shaped density distribution.

0014 Therefore, although the conventional device is capable of etching an entire substrate surface more uniformly than devices preceding the conventional device, in some cases, it cannot be necessarily said that the conventional device is sufficient as a device for etching an entire substrate surface with higher uniformity.

0015 Particularly, a semiconductor device for power control having a super junction structure with high pressure resistance and low on-resistance requires, in the process of manufacturing it, for example, forming trenches having a high aspect ratio by plasma etching of an epitaxial layer of n-conductivity type, and then embedding a layer of p-conductivity type into the trenches; the degree of embedding of the layer of p-conductivity type into the trenches varies depending on a side wall angle of the trenches, etc. Therefore, in order to uniformly embed the layer of p-conductivity type into each of the trenches formed in the substrate, it is necessary to suppress the occurrence of a tilt more rigorously as compared with the conventional art to allow the trenches to have a uniform side wall angle. Therefore, in the plasma etching when manufacturing the semiconductor device, it is required that the in-plane density of plasma have higher uniformity as compared with the conventional art.

0016 Further, there is the case where the semiconductor device is manufactured by forming trenches having a large aspect ratio in a silicon substrate and then forming a layer of p-conductivity type and a layer of n-conductivity type by implanting ions into side walls of the trenches, and in this case, the amount of ions implanted into the side walls depends on the side wall angles of the trenches. Therefore, also in this case, it is necessary to suppress the occurrence of a tilt as much as possible to improve uniformity of the side wall angles of the trenches; therefore, the in-plane density of plasma at the time of plasma etching is required to have high uniformity.

0017 Furthermore, in MEMS sensors such as a gyroscope and an accelerometer, based on a characteristic such as change of electrostatic capacity when a micromachined structure vibrates, angular velocity or acceleration is detected; the mass of the structure plays an important role in the detection performance. However, the mass of a structure greatly varies depending on the presence of a tilt; therefore, in order to manufacture a sensor having no problem in its detection performance, it is important to suppress the occurrence of a tilt as much as possible to reduce variation in the mass of a structure. Therefore, also in manufacturing an MEMS sensor, it is necessary to micro-machine a structure by plasma etching in the state where uniformity of the in-plane density of the plasma is improved as compared with the conventional art.

0018 The present invention has been achieved in view of the above-described circumstances, and an object thereof is to provide a plasma etching device capable of further uniformizing the in-plane density of plasma and uniformly etching an entire substrate surface even when it is a large-size substrate and capable of suppressing the occurrence of a tilt.

### Solution to Problem

0019 The present invention, for solving the above-described problems, relates to a plasma etching device with the features of claim 1.

0020 It is noted that, in the above-mentioned plasma etching device, the plasma density adjusting member has a tapered shape whose upper end portion has a diameter larger than that of its lower end portion and the lower end portion of the core member has a tapered shape whose diameter is reduced toward the lower end surface thereof.

0021 According to this plasma etching device, first, RF power is applied to the coil by the coil power supply mechanism to generate an inductive electric field in the plasma generation space in the chamber. Subsequently, in this state, a processing gas is supplied into the plasma generation space by the processing gas supply mechanism. Thereby, plasma is generated from the supplied processing gas by the inductive electric field.

0022 The thus generated plasma has a relatively high density since the plasma generation space is formed in a doughnut shape and the plasma is generated at a portion close to the coil where the inductive electric field easily functions.

0023 Thereafter, this high-density plasma flows downward along a surface of the core member and an inner surface of the plasma density adjusting member between the core member and the plasma density adjusting member, flows through the plasma density adjusting member from the upper end opening to the lower end opening, and reaches a substrate placed on the platen positioned below the plasma density adjusting member and etches a surface of the substrate.

0024 Thus, in the plasma etching device of the present invention, the plasma is led to the central portion of the chamber by allowing the plasma to flow through the plasma density adjusting member having a tapered shape whose upper end portion has a diameter larger than that of its lower end portion. Further, since the lower end portion of the core member has a tapered portion formed thereon having a diameter reduced toward the lower end surface thereof, the generated plasma diffuses toward the central portion of the camber along the tapered portion of the core member. That is, in the plasma etching device of the present invention, the action of the plasma density adjusting member and the action of the core member having a tapered shape are combined together, which remarkably improves diffuseness of the plasma toward the central portion of the chamber as compared with the conventional device and enables in-plane density of the plasma to be much more uniform. Consequently, it is possible to suppress a tilted etching shape (occurrence of a tilt) caused by slight ununiformity of in-plane density of plasma, and it is also possible to etch the entire substrate surface with high uniformity.

0025 It is noted that the angle between a horizontal plane and the generatrix of the tapered portion of the plasma density adjusting member is in the range of 52°-81°. The reason therefor is that when the angle is smaller than 52°, a too large amount of plasma is focused to the central portion of the chamber and the in-plane density of plasma at the outer peripheral portion of the chamber is lowered, while when the angle is larger than 81°, the effect of leading the plasma to the central portion of the chamber, that is, diffuseness of the plasma to the central portion is lowered and the in-plane density of plasma at the central portion of the chamber is lowered; in both cases, it is hard to make the in-plane density of plasma uniform all over. Further, the angle between a horizontal plane and the generatrix of the tapered portion of the core member is equal to or larger than 80° but smaller than 90°. The reason therefor is that when the angle is smaller than 80°, the diffusion of the plasma to the central portion of the chamber proceeds too much and the in-plane density of plasma at the outer peripheral portion of the chamber is therefore lowered, while when the angle is equal to or larger than 90°, the diffuseness of the plasma to the central portion of the chamber is lowered and the in-plane density of plasma at the central portion of the chamber is lowered; also in these cases, it is hard to make the in-plane density of plasma uniform all over. Thus, by setting the angle between a horizontal plane and the generatrix of the tapered portion of the plasma density adjusting member and the angle between a horizontal plane and the generatrix of the tapered portion of the core member within the above-mentioned numerical ranges, the action of the plasma density adjusting member and the action of the core member are combined, which allows the plasma to smoothly diffuse to the central portion of the chamber and further improves uniformity of the in-plane density of plasma.

0026 Further, it is preferred that the angle of the tapered portion of the plasma density adjusting member and the angle of the tapered portion of the core member are the same angle. When thus configured, it is possible to more smoothly diffuse the plasma to the central portion of the chamber, thereby making the in-plane density of plasma more uniform.

0027 Further, in the above plasma etching device, it is preferred that the lower end surface of the core member is positioned above a plane including the upper end surface of the plasma density adjusting member. When thus configured, it is possible to smoothly diffuse the plasma to the central portion of the chamber, thereby making the in-plane density of plasma more uniform.

0028 By the way, in the above plasma etching device, RF power absorbed in the plasma can be made larger by enlarging the plasma generation space, that is, increasing the circumferential cross-sectional area of the plasma in the plasma generation space, which enables large-diameter and large-area plasma to be generated. However, increasing the circumferential cross-sectional area of the plasma causes reduction of the plasma density per unit area and per unit volume. Further, even if the circumferential cross-sectional area of the plasma is increased, RF power does not effectively enter the plasma over the distance the effect of radio frequency reaches (skin depth). Further, according to knowledge of the inventors of the present application, when supplying RF powers of different frequencies in the range of approximately 10 MHz to 100 MHz, the skin depth of the plasma is in the range of approximately 10 mm to 50 mm.

0029 Taking this point into account, it is preferred that the above plasma etching device has a configuration in which the value resulting from subtracting a diameter B of the core member from an inner diameter A of the chamber is larger than 50 mm and the inner diameter A of the chamber is larger than a diameter N of the substrate.

0030 Further, it is preferred that a heating mechanism heating the core member is provided. With this configuration, when etching a substrate using a fluorocarbon-containing gas as a passivation film forming gas, it is possible to suppress adhesion of fluorocarbon-containing deposits which affect stability of the etching rate.

0031 It is noted that, although the plasma includes radicals and ions, in-plane density of ion tends to be somewhat higher at the outer peripheral portion of the chamber than at the central portion of the chamber. Therefore, in the above plasma etching device, it is preferred that the plasma density adjusting member is made of a grounded conductive material. With this configuration, when the plasma passes through the plasma density adjusting member, the ions located at the outer peripheral portion are brought into contact with the plasma density adjusting member and thereby electricity is removed and the ions are neutralized; therefore, it is possible to make the in-plane density of ion in the plasma more uniform. Thereby, it is possible to etch an entire substrate surface with higher uniformity.

0032 It is noted that the concept "reduced diameter" in the present application includes not only the case where the diameter linearly decreases like a tapered shape but also the case where the diameter curvedly decreases.

0033 Further, the "doughnut shape" in the present application means a torus shape and it shall include a case where a part of or an entire hollow cylindrical shape or ring shape includes a tapered portion or an arc portion.

### Advantageous Effects of Invention

0034 As described above, according to the plasma etching device of the present invention, plasma is diffused and led to the central portion of the chamber by the plasma density adjusting member and the core member; therefore, because of their synergistic effect, uniformity of the in-plane density of plasma can be remarkably improved as compared with the conventional device. Therefore, it is possible to suppress a tilted etching shape caused by slight ununiformity of the in-plane density of plasma, and it is also possible to much more uniformly etch an entire substrate surface.

### Brief Description of Drawings

0035
Fig. 1 is a front cross-sectional view of a plasma etching device according to one embodiment of the present invention;
Fig. 2 is an explanatory diagram for explaining a process in which plasma diffuses in the plasma etching device according to the embodiment;
Fig. 3 is an explanatory diagram for explaining the process in which plasma diffuses in the plasma etching device according to the embodiment;
Fig. 4 is an explanatory diagram for explaining the dimensions of an exemplary device 1;
Fig. 5 is a graph relating to in-plane density of plasma when generating plasma from SF₆ gas using the exemplary device 1;
Fig. 6 is a graph relating to in-plane density of plasma when generating plasma from SF₆ gas using a comparative device 1;
Fig. 7 is a graph relating to etching rate when etching an oxide film on a silicon substrate using the exemplary device 1;
Fig. 8 is a graph relating to etching rate when etching an oxide film on a silicon substrate using the comparative device 1;
Fig. 9 is a graph relating to a tilt state on a silicon substrate etched using the exemplary device 1;
Fig. 10 shows photographs of cross sections of a silicon substrate etched using the exemplary device 1, wherein the distance in the radial direction from the center of the substrate is 0 mm, 40 mm, 80 mm and 97 mm in photographs (a) to (d), respectively;
Fig. 11 is an explanatory diagram for explaining the dimensions of an exemplary device 2;
Fig. 12 is an explanatory diagram for explaining the dimensions of an exemplary device 3;
Fig. 13 is a graph relating to in-plane density of plasma when generating plasma from SF₆ gas using the exemplary device 2;
Fig. 14 is a graph relating to in-plane density of plasma when generating plasma from SF₆ gas using the exemplary device 3; and

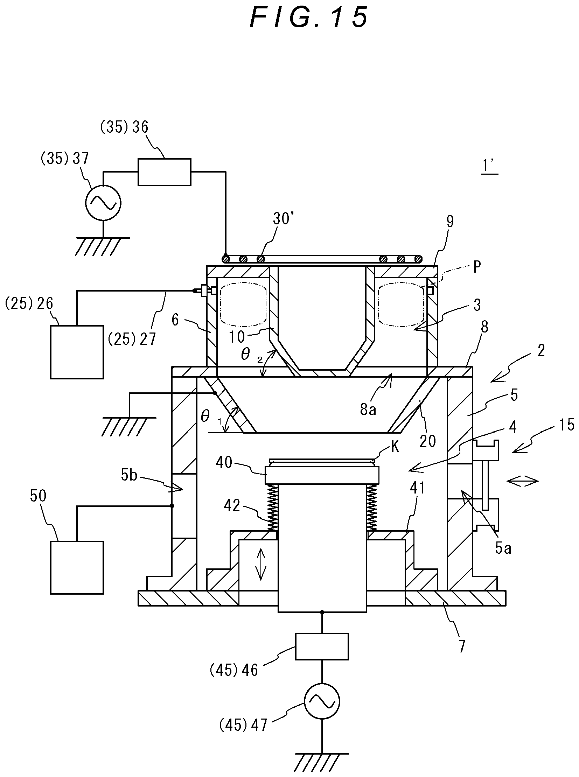

Fig. 15 is a front cross-sectional view of a plasma etching device according to another embodiment of the present invention.

### Description of Embodiments

0036 A specific embodiment of the present invention will be described below based on the drawings.

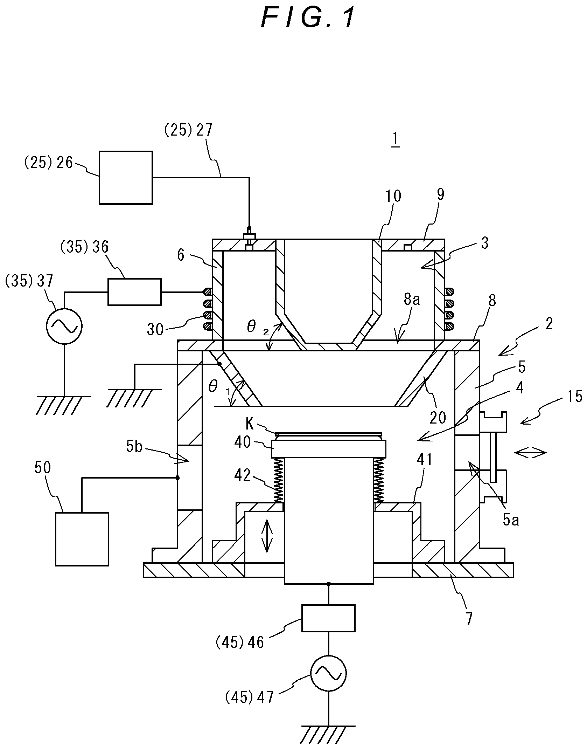

0037 As shown in Fig. 1, a plasma etching device 1 of this embodiment includes a cylindrical chamber 2 having a plasma generation space 3 set in an upper inner space thereof and a processing space 4 set below the plasma generation space 3, an etching gas supply mechanism 25 supplying an etching gas into the plasma generation space 3, a coil 30 disposed outside a portion of the chamber 2 where the plasma generation space 3 is set, a coil power supply mechanism 35 supplying RF power to the coil 30, a platen 40 disposed in the processing space 4 for placing a substrate K thereon, a platen power supply mechanism 45 supplying RF power to the platen 40, and an exhaust device 50 exhausting gas inside the chamber 2.

0038 The chamber 2 is formed by a lower body portion 5, an upper body portion 6, a bottom plate 7, an intermediate plate 8 and a top plate 9. The bottom plate 7 and the intermediate plate 8 are fixed on a lower end portion and an upper end portion of the lower body portion 5, respectively, and the processing space 4 is formed by the lower body portion 5, the bottom plate 7 and the intermediate plate 8. Further, the upper body portion 6 has an lower end portion fixed on the intermediate plate 8 and a upper end portion fixed to the top plate 9 and a cylindrical core member 10 is arranged at a central portion of the top plate 9 so that it hangs downward from the top plate 9, and the plasma generation space 3 of a doughnut shape is formed by the upper body potion 6, the intermediate plate 8, the top plate 9 and the core member 10. It is noted that the inner diameter of the upper body portion 6 is larger than the outer diameter of the substrate K.

0039 The lower body portion 5 has an opening 5a formed thereon for loading in and out the substrate K and has an exhaust port 5b formed thereon for exhausting gas inside the processing space 4. The opening 5a is configured to be opened and closed by a shutter mechanism 15, while the exhaust port 5b is connected to the exhaust device 50 and gas inside the chamber 2 is exhausted by the exhaust device 50.

0040 Further, the intermediate plate 8 has an opening 8a formed thereon and has a plasma density adjusting member 20 fixed on a lower surface thereof; the plasma density adjusting member 20 is made of an annular member that has an open upper end portion and an open lower end portion and is formed in a tapered shape whose upper end portion has a diameter larger than that of its lower end portion. The plasma generation space 3 and the processing space 4 communicate with each other through the opening 8a and the plasma density adjusting member 20. It is noted that, in view of suppressing decrease in plasma density caused by a too large distance between the plasma generation space 3 and the platen 40 and preventing a too small distance between the plasma generation space 3 and the platen 40 so as to reduce damage by plasma and in view of good diffusion of the plasma to a central portion of the chamber 2, it is preferred that the angle between a horizontal plane and the generatrix of the tapered portion of the plasma density adjusting member 20, or specifically, the angle θ₁ between a horizontal plane and an inner peripheral surface of the tapered portion of the plasma density adjusting member 20 is set in the range of 52° to 81°.

0041 The plasma density adjusting member 20 is positioned between the plasma generation space 3 and the platen 40, and is made of a material having conductivity (for example, aluminum) and is grounded as appropriate. Further, the inner diameter of the lower end portion of the plasma density adjusting member 20 is smaller than the inner diameter of the upper body portion 6.

0042 Further, the core member 10 is extended to a position where its lower end surface is positioned on the same plane as a plane including the upper end surface of the plasma density adjusting member 20, and a lower end portion of the core member 10 has a tapered portion formed thereon whose diameter is recued toward the lower end surface. It is noted that, in view of good diffusion of the plasma to the central portion of the chamber 2 to further improve uniformity of the in-plane density of plasma, it is preferred that the angle between a horizontal plane and the generatrix of the tapered portion of the core member 10, or specifically, the angle θ₂ between a horizontal plane and an outer peripheral surface of the tapered portion of the core member 10 is set to be equal to or larger than 80° but smaller than 90°.

0043 It is noted that the angles θ₁ and θ₂ are set to the same value in the plasma etching device of this embodiment. By thus setting these angles to the same value, more smooth diffusion of the plasma to the central portion of the chamber 2 is achieved, thereby enabling the plasma in the chamber 2 to have a uniform in-plane density and be stable.

0044 The etching gas supply mechanism 25 includes an etching gas supply source 26 storing an etching gas therein and a supply pipe 27 having one end connected to the etching gas supply source 26 and the other end connected to a plurality of discharge ports provided to be arranged in an annular form on the top plate 9. By the etching gas supply mechanism 25, the etching gas is uniformly discharged vertically downward from the plurality of discharge ports through the etching gas supply source 26 and the supply pipe 27 and thereby the etching gas is supplied into the plasma generation space 3.

0045 The coil 30 is disposed outside the upper body portion 6 to wind around it, and RF power is supplied to the coil 30 by the coil power supply mechanism 35, which is described below.

0046 Further, the coil power supply mechanism 35 includes a matching unit 36 connected to the coil 30 and an RF power supply unit 37 connected to the machining unit 36 and, as described above, supplies RF power to the coil 30.

0047 The platen 40 is disposed in the processing space 4 and is configured to be lifted up and down by an appropriate lifting mechanism (not shown) in a state where it is supported by a support 41 to be movable up and down in the vertical direction. It is noted that an outer peripheral portion of the platen 40 is covered by a bellows 42.

0048 The platen power supply mechanism 45 includes a matching unit 46 connected to the platen 40 and an RF power supply unit 47 connected to the matching unit 46 and supplies RF power to the platen 40.

0049 Next, a process of etching a substrate K (silicon substrate) using the plasma etching device 1 having the above-described configuration is described.

0050 First, the substrate K (for example, a silicon substrate) is placed on the platen 40, which is positioned at a lift-down position, through the opening 5a. Subsequently, the platen 40 is lifted up to a processing position by the lifting mechanism, and then gas inside the chamber 2 (the plasma generation space 3 and the processing space 4) is exhausted by the exhaust device 50 to set the pressure inside the chamber 2 to a negative pressure and RF power is supplied to the platen 40 from the RF power supply unit 47.

0051 Further, simultaneously with this, RF power is supplied to the coil 30 from the RF power supply unit 37 to generate an inductive electric field in the plasma generation space 3. By supplying an etching gas (for example, SF₆ gas) into the plasma generation space 3 from the etching gas supply source 26 in this state, plasma is generated from the etching gas due to the inductive electric filed.

0052 At that time, since the plasma generation space 3 is formed in a doughnut shape by the core member 10 as described above and the volume thereof is therefore smaller as compared with the case where the core member 10 is not provided, and since the plasma generation space 3 is formed by only a portion close to the coil 30, high-density plasma is generated even if a relatively small power is applied to the coil 30 as compared with the case where the core member 10 is not provided.

0053 Then, the thus generated high-density plasma flows downward along the surface of the core member 10 and the inner surface of the plasma density adjusting member 20 between the core member 10 and the plasma density adjusting member 20, flows through the plasma density adjusting member 20 and reaches the substrate K positioned blow the plasma density adjusting member 20, and etches the surface of the substrate K.

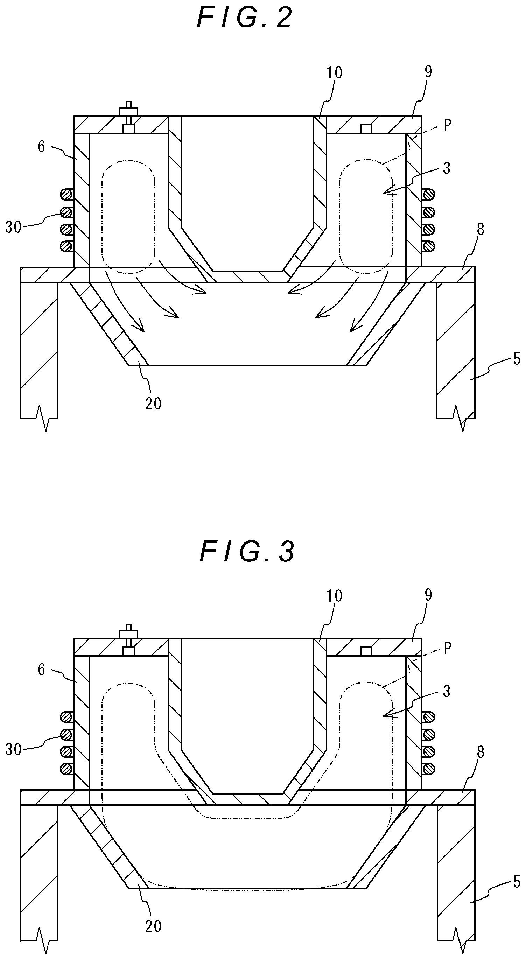

0054 Here, in the plasma etching device 1 of this embodiment, since the core member 10 has the tapered portion formed at the lower end portion thereof, the plasma generated in the plasma generation space 3 (P in Figs. 2 and 3) gradually diffuses to the central portion of the chamber 2 along the tapered portion of the core member 10, and further the plasma is gradually focused to the central portion of the chamber 2 by flowing through the tapered plasma density adjusting member 20 (see Figs. 2 and 3). Thereby, in-plane density of the generated plasma is gradually leveled and the density distribution is adjusted to a very gentle, concave or M-shaped state or a flat, uniform state. Because the plasma having such a density state functions on the surface of the substrate K, tilt of etching shape caused by ununiformity of the in-plane density of plasma is suppressed and the entire surface of the substrate K is etched uniformly.

0055 It is noted that, in this embodiment, a bias potential is applied to the substrate K by applying RF to the platen 40. Therefore, ions in the plasma are irradiated onto the substrate K, and thereby the so-called ion assisted etching is performed.

0056 Further, in the plasma etching device 1 of this embodiment, because the plasma density adjusting member 20 is made of a grounded conductive material, when the plasma passes through the plasma density adjusting member 20, ions located at an outer peripheral portion of the plasma are brought into contact with the plasma density adjusting member 20 and thereby electricity is removed and the ions are neutralized and eliminated. Although the plasma includes ions and radicals, in-plane density of ion tends to be somewhat higher at the outer peripheral side of the chamber 20 than at the central side thereof. Therefore, eliminating the ions located at the outer peripheral portion of the chamber by removal of electricity and neutralization makes it possible to make the in-plane density of ion more uniform. Further, making the in-plane density of ion more uniform as described above makes it possible to etch the entire surface of the substrate K with higher uniformity.

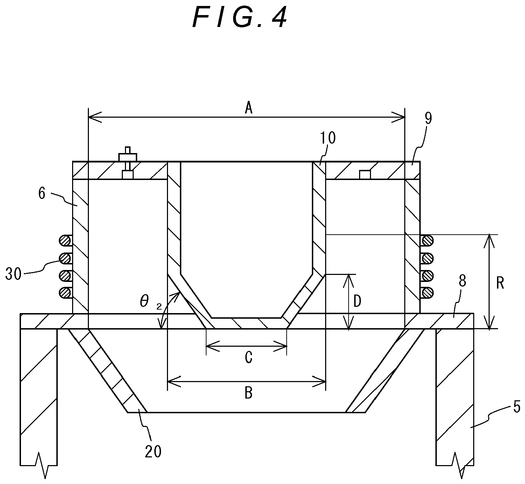

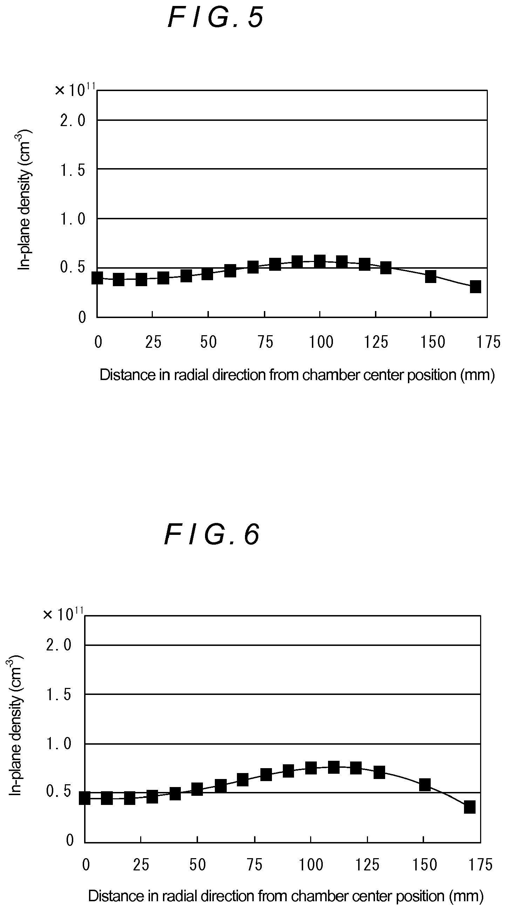

0057 In this connection, in the plasma etching device 1 of this embodiment (exemplary device 1), the in-plane density of plasma when SF₆ gas is employed as the etching gas and plasma is generated from SF₆ gas was measured, where the supply flow rate of SF₆ gas supplied into the plasma generation space 3 was 200 sccm; the RF power applied to the coil 30 was 1200 W; and, as shown in Fig. 4, the inner diameter A of the upper body portion 6, the diameter B of the core member 10, the diameter C of the lower end surface of the core member 10, the vertical length D of the tapered portion of the core member 10, and the angle θ₂ of the core member 10 were 270 mm, 170 mm, 130 mm, 95 mm, and 80.75°, respectively. The results are shown in Fig. 5.

0058 Further, for comparison, in a plasma etching device (comparative device 1) including a core member having no tapered portion provided thereon instead of the core member 10 having the tapered portion provided thereon, the in-plane density of plasma when plasma is generated from SF₆ gas was measured, where the supply flow rate of SF₆ gas supplied into the plasma generation space 3 was 200 sccm and the RF power applied to the coil 30 was 2000 W. The results are shown in Fig. 6.

0059 When comparing the measurement results of the exemplary device 1 and the comparative device 1, the degree of diffusion of the plasma to the chamber central portion is greater in the exemplary device 1 (see Figs. 5 and 6). Further, when calculating uniformity of a wafer having the diameter of 200 mm, it was 19.3 % in the exemplary device 1, while it was 27.5 % in the comparative device 1. From these results, it is realized that providing a tapered portion on the core member remarkably improves diffuseness of the plasma to the chamber central portion; which results in increase in the in-plane density of plasma.

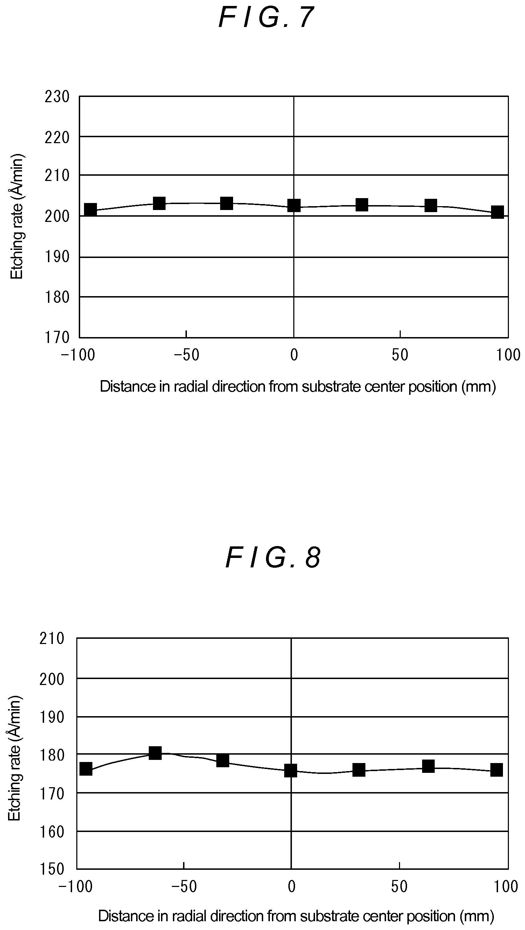

0060 Further, using the exemplary device 1, an oxide film (SiO₂) on a silicon substrate of 8 inches was etched using SF₆ gas as the etching gas, where the supply flow rate of SF₆ gas supplied into the plasma generation space 3 was 400 sccm; the RF power applied to the coil 30 was 2000 W; and the RF power applied to the platen 40 was 50 W. The results are shown in Fig. 7.

0061 Further, for comparison, using the comparative device 1, a silicon substrate of 8 inches was similarly etched using SF₆ gas as the etching gas, where the supply flow rate of SF₆ gas supplied into the plasma generation space was 400 sccm; the RF power applied to the coil was 2000 W; and the RF power applied to the platen was 50 W. The results are shown in Fig. 8.

0062 In the exemplary device 1, the etching rate was almost uniform over the entire substrate surface (see Fig. 7); the etching rate over the entire substrate surface was 202 Å/min ± 0.9 %. On the other hand, in the comparative device 1, variation in the etching rate was seen over the entire substrate surface (see Fig. 8); the etching rate over the entire substrate surface was 176 Å/min ± 2.7 %. From this result, it is realized that, as described above, providing a tapered portion on the core member promotes diffusion of the plasma to the chamber central portion, and thereby uniformity of the in-plane density of plasma is remarkably increased and the plasma having more uniform in-plane density functions on the entire substrate surface; therefore, the substrate surface is etched more uniformly.

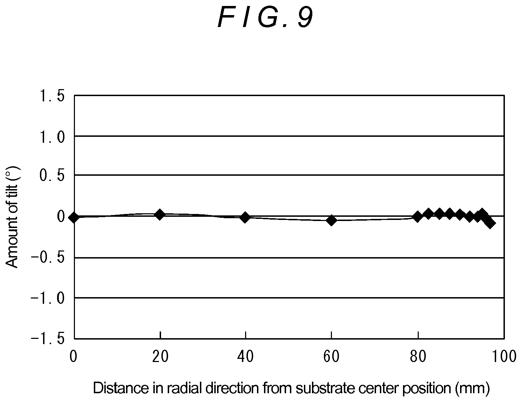

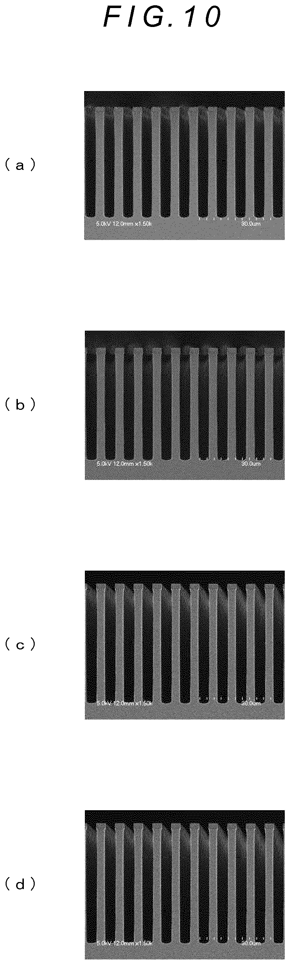

0063 Furthermore, using the exemplary device 1, a silicon substrate of 8 inches was etched by the so-called Bosch process using SF₆ gas as the etching gas and C₄F₈ gas as a passivation film forming gas and the presence of tilt was considered, where the supply flow rate of SF₆ gas was 500 sccm; the supply flow rate of C₄F₈ gas was 100 sccm; and these gases were alternately supplied into the plasma generation space 3. It is noted that the etching was performed by applying the RF power of 700 W to the coil 30 and applying the RF power of 160 W to the platen 40. The results are shown in Figs. 9 and 10. It is noted that Fig. 10 shows photographs of cross sections of the substrate, wherein the distance in the radial direction from the position of the center of the substrate to the position of the cross section is 0 mm, 40 mm, 80 mm, and 97 mm in the order from (a) to (d).

0064 As shown in Figs. 9 and 10, when etching a silicon substrate using the exemplary device 1, a tilt hardly occurred over the entire surface of the substrate and the amount of tilt was less than 0.1 degree even at the position whose distance from the position of the center of the substrate was 97 mm. From this result, it is realized that, as described above, providing a tapered portion on the core member improves uniformity of the in-plane density of plasma and the plasma having an in-plane density of high uniformity functions on the substrate, which suppresses the occurrence of tilt.

0065 Thus, in the plasma etching device of this embodiment, since a tapered portion is provided on the core member and the tapered plasma density adjusting member is provided, due to a synergistic effect of the core member and the plasma density adjusting member, the in-plane density of plasma can be made more uniform than that in the conventional art, and an entire substrate surface on which this plasma functions can be etched uniformly.

0066 Further, since it is possible to etch an entire substrate surface with plasma having an in-plane density uniformity higher than that in the conventional art and it is possible to suppress the occurrence of tilt more remarkably as compared with the conventional art, the plasma etching device can be preferably used for manufacturing a semiconductor device having a super junction structure, an MEMS sensor and the like.

0067 Although one embodiment of the present invention has been described above, a specific mode that can be adopted in the present invention is not limited thereto at all.

0068 For example, although the angle θ₁ and the angle θ₂ are set to the same value in the plasma etching device 1 of this embodiment, the angles may be set to values different from each other so as to allow the generated plasma to smoothly diffuse.

0069 Further, although the inner diameter A of the upper body portion 6 (inner diameter A of the chamber) and the diameter B of the core member 10 are 270 mm and 170 mm, respectively, in the plasma etching device 1, the present invention is not limited thereto and it is preferred that they are set as appropriate depending on the plasma skin depth.

0070 In this connection, when the inventors of the present application calculated the plasma skin depth when supplying RF of different frequencies in the range of 13.56 MHz to 100 MHz, where the radius of a gas molecule was 2 x 10⁻¹² m; the pressure was 5 Pa; the electron temperature was 3 eV; and the plasma density is 1 x 10¹² cm⁻³, the calculated skin depth was in the range of 23.9 mm to 8.8 mm. In the case where the pressure was set to 20 Pa at the frequency of 13.56 MHz, the skin depth was increased to 50 mm. Taking this result into account, in order to form a plasma generation space whose total length in the circumferential direction is equal to or larger than 50 mm, it is preferred that the value resulting from subtracting the diameter B of the core member 10 from the inner diameter A of the upper body portion 6 is larger than 50 mm.

0071 Further, a heating mechanism heating the core member 10 may be provided. When thus configured, in the case where the substrate K is etched using a fluorocarbon-containing gas such as C₄F₈ gas as a passivation film forming gas, it is possible to suppress adhesion of fluorocarbon-containing deposits and ensure stability of the etching rate.

0072 Further, although the plasma etching device 1 of this embodiment has the configuration in which the plasma density adjusting member 20 and the lower end portion of the core member 10 each have a tapered shape, the present invention is not limited thereto. For example, the plasma density adjusting member 20 may have such a shape that a part of its diameter or its entire diameter curvedly decreases from its upper end portion toward its lower end portion. Further, the lower end portion of the core member 10 may have such a shape that a part of its diameter or its entire diameter curvedly decreases toward its lower end surface. When thus configured, a corresponding effect can be obtained.

0073 Furthermore, although, in the plasma etching device 1 of this embodiment, as the most preferable mode, the lower end surface of the core member 10 is positioned on the same plane as the plane including the upper end surface of the plasma density adjusting member 20, the present invention is not limited thereto. With a configuration in which the lower end surface of the core member 10 is positioned between the plane including the upper end surface of the plasma density adjusting member 20 and a plane including the upper end of the coil 30 (in the region indicated by R in Fig. 4), a corresponding effect can be obtained.

0074 Further, the lower end surface of the core member 10 may be positioned below the plane including the upper end surface of the plasma density adjusting member 20. When thus configured, a corresponding effect can be obtained.

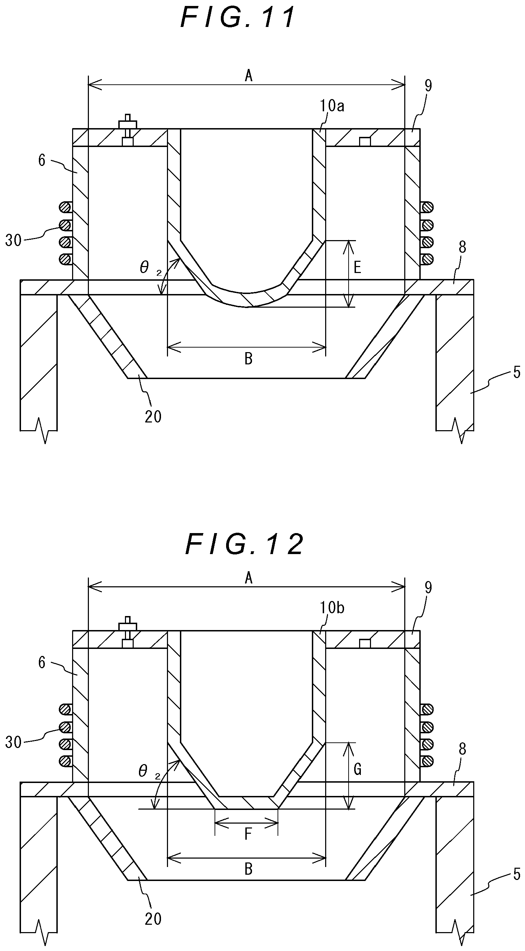

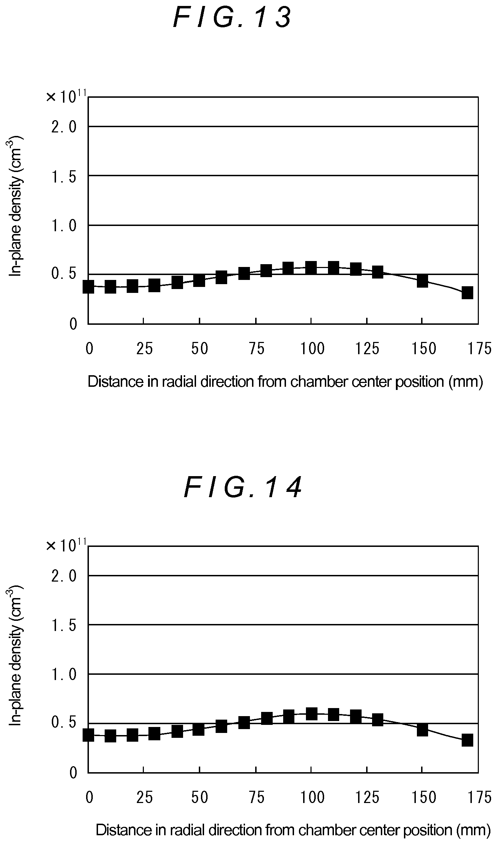

0075 In this connection, in an exemplary device 2 having a core member 10a and an exemplary device 3 having a core member 10b, the core members 10a and 10b each having a shape different from that of the core member 10 of the plasma etching device 1 of the above embodiment, the in-plane density of plasma when using SF₆ gas as the etching gas and generating plasma from SF₆ gas was measured, where the supply flow rate of SF₆ gas supplied into the plasma generation space 3 was 200 sccm and the RF power applied to the coil 30 was 1200 W. The results are shown in Figs. 13 and 14. It is noted that, in the exemplary device 2, as shown in Fig. 11, the lower end portion of the core member 10a had a spherical surface having the radius of 260 mm and the vertical length E from the lower end portion to the uppermost portion of the tapered portion of the core member 10a was 106 mm, while, in the exemplary device 3, as shown in Fig. 12, the diameter F of the lower end surface of the core member 10b was 93 mm and the vertical length G of the tapered portion on the core member 10b was 106 mm. It is noted that, in each of the exemplary devices 2 and 3, the inner diameter A of the upper body portion 6, the diameter B of the core member 10a, 10b, and the angle θ₂ of the tapered portion of the core member 10a, 10b are the same as those in the plasma etching device 1.

0076 In comparison of the measurement results in the exemplary device 1, the exemplary device 2, the exemplary device 3 and the comparative device 1, although the degree of diffusion of the plasma to the chamber central portion in each of the exemplary device 2 and the exemplary device 3 is somewhat smaller than that in the exemplary device 1, it can be seen that it is remarkably greater than that in the comparative device 1 (see Figs. 5, 6, 13 and 14). Further, as described above, the uniformity of a wafer having the diameter of 200 mm was 19.3 % in the exemplary device 1 and 27.5 % in the comparative device 1, while it was 22.4 % in the exemplary device 2 and 24.3 % in the exemplary device 3; therefore, even though the uniformity in each of the exemplary devices 2 and 3 was somewhat lower than that in the exemplary device 1, it was remarkably higher than that in the comparative device 1.

0077 Thus, although it is preferred that the lower end surface of the core member is positioned above the plane including the upper end surface of the plasma density adjusting member, even if it is positioned below the plane including the upper end surface of the plasma density adjusting member, diffuseness of the plasma to the central portion can be improved and thereby the uniformity of the in-plane density of plasma can be increased.

0078 Furthermore, although the plasma etching device 1 of this embodiment has the configuration in which the coil 30 is disposed outside the upper body portion 6 to wind around it, the present invention is not limited to this configuration. For example, like a plasma etching device 1' shown in Fig. 9, a configuration may be adopted in which an annular coil 30' is disposed at a position above the top plate 9, which is outside the portion of the chamber 2 corresponding to the plasma generation space 3. It is noted that, in Fig. 9, the same components as those of the plasma etching device 1 are denoted by the same reference numerals. Also in this plasma etching device 1', the plasma density adjusting member 20 has a tapered shape, the core member 10 has a tapered portion formed on a lower end portion thereof, and the lower end surface of the core member 10 is positioned below the upper end of the coil 30'. Therefore, similarly to the plasma etching device 1, the plasma generated in the plasma generation space 3 (P in Fig. 9) gradually diffuses to the central portion of the chamber 2 along the tapered portion of the core member 10 and the plasma flows through the tapered plasma density adjusting member 20, and thereby the plasma is gradually focused to the central portion of the chamber 2. Thereby, the in-plane density of the generated plasma is gradually leveled and the density distribution is adjusted to a very gentle, concave or M-shaped state or a flat, uniform state, and the plasma having such a density distribution functions on the surface of the substrate K. Therefore, with such a configuration, similar effects as those of the plasma etching device 1 can be obtained.

### Reference Signs List

0079
- 1: Plasma etching device
- 2: Chamber
- 3: Plasma generation space
- 4: Processing space
- 5: Lower body portion
- 6: Upper body portion
- 7: Bottom plate
- 8: Intermediate plate
- 9: Top plate
- 10: Core member
- 20: Plasma density adjusting member
- 25: Etching gas supply mechanism
- 30: Coil
- 35: Coil power supply mechanism
- 40: Platen
- 45: Platen power supply mechanism

## Claims

1. A plasma etching device (1) comprising:
a chamber (2) including a tubular body portion (5, 6), a top plate (9) to close an upper portion of the body portion (5, 6), and a bottom plate (7) to close a bottom portion of the body portion (5, 6) and having a plasma generation space (3) set in an upper region in the body portion (5, 6) and a processing space (4) set below the plasma generation space (3);
an annular coil (30) disposed outside a portion of the chamber (2) corresponding to the plasma generation space (3);
a platen (40) disposed in the processing space (4) in the chamber (2) for placing a substrate (K) to be processed thereon;
a processing gas supply mechanism (25) supplying a processing gas into the plasma generation space (3) in the chamber (2);
an exhaust mechanism (50) exhausting at least gas inside the processing space (4) in the chamber (2);
a coil power supply mechanism (35) supplying RF power to the coil (30);
a platen power supply mechanism (45) supplying RF power to the platen (40);
a plasma density adjusting member (20) comprising an annular member having an open upper end portion and an open lower end portion and having a shape with a diameter reduced toward the lower end portion, the upper end portion being fixed on an inner wall of the chamber (2) between the plasma generation space (3) and the platen (40), the plasma density adjusting member (20) adjusting in-plane density of plasma generated in the plasma generation space (3) and leading the plasma to the substrate (K) placed on the platen (40), the plasma density adjustment member (20) has a tapered shape with an upper end portion having a diameter larger than that of a lower end portion thereof;
a cylindrical core member (10) arranged to extend downward from a central portion of the top plate (9) so that at least an lower end thereof is positioned below an upper end of the coil (30) in a vertical direction;
the body portion (5) forming the plasma generation space (3) being formed to have an inner diameter larger than an outer diameter of the substrate (K); and
the plasma generation space (3) being formed in a doughnut shape by the core member (10),
**characterized in that**
the core member (10) has a lower end portion having a shape with a diameter reduced toward a lower end surface thereof,
the lower end portion of the core member (10) has a tapered shape having a diameter decreasing toward the lower end surface thereof,
an angle (θ₁) between a horizontal plane and a generatrix of the tapered portion of the plasma density adjusting member (20) is in a range of 52°-81°, and
an angle (θ₂) between a horizontal plane and a generatrix of the tapered portion of the core member (10) is equal to or larger than 80° but smaller than 90°.

2. The plasma etching device (1) according to claim 1, **characterized in that**
the angle (θ₁) of the tapered portion of the plasma density adjusting member (20) and the angle (θ₂) of the tapered portion of the core member (10) are a same angle.

3. The plasma etching device (1) according to claim 1 or 2, **characterized in that**
the lower end surface of the core member (10) is positioned above a plane including an upper end surface of the plasma density adjusting member (20).

4. The plasma etching device (1) according to any one of claims 1 to 3, **characterized in that**
the plasma density adjusting member (20) comprises a grounded conductive material.

5. The plasma etching device (1) according to any one of claims 1 to 4, **characterized in that**
a value resulting from subtracting a diameter B of the core member (10) from an inner diameter A of the chamber (2) is larger than 50 mm, and
the inner diameter A of the chamber (2) is larger than a diameter N of the substrate (K).

6. The plasma etching device (1) according to any one of claims 1 to 5, **characterized in that** a heating mechanism heating the core member (10) is provided.

## Patentansprüche

1. Plasmaätzvorrichtung (1), umfassend:
eine Kammer (2), die einen röhrenförmigen Körperabschnitt (5, 6), eine Deckplatte (9) zum Verschließen eines oberen Abschnitts des Körperabschnitts (5, 6) und eine Bodenplatte (7) zum Verschließen eines unteren Abschnitts des Körperabschnitts (5, 6) umfasst und die einen Plasmagenerierungsraum (3) aufweist, der in einer oberen Region in dem Körperabschnitt (5, 6) angeordnet ist, und einen Verarbeitungsraum (4) aufweist, der unter dem Plasmagenerierungsraum (3) angeordnet ist;
eine ringförmige Spule (30), die außerhalb eines Abschnitts der Kammer (2), der dem Plasmagenerierungsraum (3) entspricht, angeordnet ist;
eine Platte (40), die in dem Verarbeitungsraum (4) in der Kammer (2) angeordnet ist und auf der ein zu verarbeitendes Substrat (K) angeordnet wird;
einen Verarbeitungsgas-Zufuhrmechanismus (25), der ein Verarbeitungsgas in den Plasmagenerierungsraum (3) in der Kammer (2) einleitet;
einen Auslassmechanismus (50), der mindestens Gas im Inneren des Verarbeitungsraums (4) in der Kammer (2) auslässt;
einen Spulenstromversorgungsmechanismus (35), der HF-Leistung in die Spule (30) einspeist;
einen Plattestromversorgungsmechanismus (45) der HF-Leistung an die Platte (40) anlegt;
ein Plasmadichteeinstellelement (20), das ein ringförmiges Element umfasst, das einen offenen oberen Endabschnitt und einen offenen unteren Endabschnitt aufweist und eine Form aufweist, bei der ein Durchmesser in Richtung des unteren Endabschnitts reduziert ist, wobei der obere Endabschnitt an einer Innenwand der Kammer (2) zwischen dem Plasmagenerierungsraum (3) und der Platte (40) befestigt ist, wobei das Plasmadichteeinstellelement (20) die Ebenendichte von Plasma einstellt, der in dem Plasmagenerierungsraum (3) generiert wurde, und das Plasma zu dem Substrat (K) leitet, das auf der Platte (40) angeordnet ist, wobei das Plasmadichteeinstellelement (20) eine verjüngte Form mit einem oberen Endabschnitt aufweist, dessen Durchmesser größer ist als der seines unteren Endabschnitts;
ein zylindrisches Kernelement (10), das so angeordnet ist, dass es sich von einem mittigen Abschnitt der Deckplatte (9) so abwärts erstreckt, dass mindestens sein unteres Ende unter einem oberen Ende der Spule (30) in einer vertikalen Richtung positioniert ist;
wobei der Körperabschnitt (5), der den Plasmagenerierungsraum (3) bildet, so gebildet ist, dass sein Innendurchmesser größer ist als ein Außendurchmesser des Substrats (K); und
der Plasmagenerierungsraum (3) durch das Kernelement (10) eine Doughnut-Form erhält,
**dadurch gekennzeichnet, dass**
das Kernelement (10) einen unteren Endabschnitt aufweist, der eine Form mit einem Durchmesser aufweist, der in Richtung seiner unteren Endfläche kleiner wird,
wobei der untere Endabschnitt des Kernelements (10) eine verjüngte Form aufweist, deren Durchmesser in Richtung seiner unteren Endfläche kleiner wird,
wobei ein Winkel (θ₁) zwischen einer horizontalen Ebene und einer Generatrix des verjüngten Abschnitts des Plasmadichteeinstellelements (20) in einem Bereich von 52°-81° liegt, und
ein Winkel (θ₂) zwischen einer horizontalen Ebene und einer Generatrix des verjüngten Abschnitts des Kernelements (10) mindestens 80°, aber weniger als 90° beträgt.

2. Plasmaätzvorrichtung (1) nach Anspruch 1, **dadurch gekennzeichnet, dass** der Winkel (θ1) des verjüngten Abschnitts des Plasmadichteeinstellelements (20) und der Winkel (θ2) des verjüngten Abschnitts des Kernelements (10) der gleiche Winkel sind.

3. Plasmaätzvorrichtung (1) nach Anspruch 1 oder 2, **dadurch gekennzeichnet, dass** die untere Endfläche des Kernelements (10) oberhalb einer Ebene positioniert ist, die eine obere Endfläche des Plasmadichteeinstellelements (20) umfasst.

4. Plasmaätzvorrichtung (1) nach einem der Ansprüche 1 bis 3, **dadurch gekennzeichnet, dass** das Plasmadichteeinstellelement (20) ein geerdetes leitfähiges Material enthält.

5. Plasmaätzvorrichtung (1) nach einem der Ansprüche 1 bis 4, **dadurch gekennzeichnet, dass**
ein Wert, der aus dem Subtrahieren eines Durchmessers B des Kernelements (10) von einem Innendurchmesser A der Kammer (2) größer als 50 mm ist, und
der Innendurchmesser A der Kammer (2) größer ist als ein Durchmesser N des Substrats (K).

6. Plasmaätzvorrichtung (1) nach einem der Ansprüche 1 bis 5, **dadurch gekennzeichnet, dass** ein Heizmechanismus vorhanden ist, der das Kernelement (10) erwärmt.

## Revendications

1. Dispositif de gravure au plasma (1) comprenant :
une chambre (2) comprenant une partie corps tubulaire (5, 6), une plaque supérieure (9) pour fermer une partie supérieure de la partie corps (5, 6) et une plaque inférieure (7) pour fermer une partie inférieure de la partie corps (5, 6) et ayant un espace de génération de plasma (3) défini dans une région supérieure dans la partie corps (5, 6) et un espace de traitement (4) défini au-dessous de l'espace de génération de plasma (3);
une bobine annulaire (30) disposée à l'extérieur d'une partie de la chambre (2) correspondant à l'espace de génération de plasma (3);
une platine (40) disposée dans l'espace de traitement (4) dans la chambre (2) sur laquelle on place un substrat (K) à traiter;
un mécanisme d'alimentation en gaz de traitement (25) fournissant un gaz de traitement dans l'espace de génération de plasma (3) dans la chambre (2);
un mécanisme d'évacuation (50) évacuant au moins des gaz à l'intérieur de l'espace de traitement (4) dans la chambre (2) ;
un mécanisme d'alimentation électrique de bobine (35) fournissant de l'énergie RF à la bobine (30);
un mécanisme d'alimentation électrique de platine (45) fournissant de l'énergie RF à la platine (40);
un élément de réglage de densité de plasma (20) comprenant un élément annulaire ayant une partie d'extrémité supérieure ouverte et une partie d'extrémité inférieure ouverte et ayant une forme dont le diamètre est réduit vers la partie d'extrémité inférieure, la partie d'extrémité supérieure étant fixée sur une paroi intérieure de la chambre (2) entre l'espace de génération de plasma (3) et la platine (40), l'élément de réglage de densité de plasma (20) réglant la densité dans le plan du plasma généré dans l'espace de génération de plasma (3) et conduisant le plasma vers le substrat (K) placé sur la platine (40), l'élément de réglage de densité de plasma (20) a une forme conique avec une partie d'extrémité supérieure ayant un diamètre supérieur à celui de sa partie d'extrémité inférieure;
un élément de noyau cylindrique (10) agencé pour s'étendre vers le bas à partir d'une partie centrale de la plaque supérieure (9) de sorte qu'au moins une extrémité inférieure de celui-ci soit positionnée sous une extrémité supérieure de la bobine (30) dans une direction verticale;
la partie de corps (5) formant l'espace de génération de plasma (3) étant formée pour avoir un diamètre intérieur supérieur à un diamètre extérieur du substrat (K); et
l'espace de génération de plasma (3) étant formé en forme de beignet par l'élément de noyau (10),
**caractérisé en ce que**
l'élément de noyau (10) a une partie d'extrémité inférieure ayant une forme dont le diamètre est réduit vers sa surface d'extrémité inférieure,
la partie d'extrémité inférieure de l'élément de noyau (10) a une forme conique ayant un diamètre diminuant vers sa surface d'extrémité inférieure,
un angle (θ1) entre un plan horizontal et une génératrice de la partie conique de l'élément de réglage de densité de plasma (20) se situe dans une plage allant de 52° à 81°, et
un angle (θ2) entre un plan horizontal et une génératrice de la partie conique de l'élément de noyau (10) est égal ou supérieur à 80°, mais inférieur à 90°.

2. Dispositif de gravure au plasma (1) selon la revendication 1, **caractérisé en ce que**
l'angle (θ1) de la partie conique de l'élément de réglage de densité de plasma (20) et l'angle (θ2) de la partie conique de l'élément de noyau (10) forment un même angle.

3. Dispositif de gravure au plasma (1) selon la revendication 1 ou 2, **caractérisé en ce que**
la surface d'extrémité inférieure de l'élément de noyau (10) est positionnée au-dessus d'un plan comprenant une surface d'extrémité supérieure de l'élément de réglage de densité de plasma (20).

4. Dispositif de gravure au plasma (1) selon l'une quelconque des revendications 1 à 3, **caractérisé en ce que**
l'élément de réglage de densité de plasma (20) comprend un matériau conducteur mis à la terre.

5. Dispositif de gravure au plasma (1) selon l'une quelconque des revendications 1 à 4, **caractérisé en ce que**
une valeur résultant de la soustraction d'un diamètre B de l'élément de noyau (10) à un diamètre intérieur A de la chambre (2) est supérieure à 50 mm, et
le diamètre intérieur A de la chambre (2) est supérieur à un diamètre N du substrat (K).

6. Dispositif de gravure au plasma (1) selon l'une quelconque des revendications 1 à 5, **caractérisé en ce qu'**un mécanisme de chauffage chauffant l'élément de noyau (10) est prévu.
